# FASCICULE DE BREVET EUROPEEN

(11) **EP 0 604 270 B1**
(45) Date de publication et mention de la délivrance du brevet: **03.04.1996**
(21) Numéro de dépôt: 93403029.7
(22) Date de dépôt: 14.12.1993
(51) Int. Cl.: G06F 1/24, G06F 1/28, G01R 19/165

(54) **Circuit de démarrage et de sécurité contre les coupures d'alimentation pour circuit intégré**
Einschalt-Rücksetzschaltung mit Schutz gegen Stromunterbrechungen für eine integrierte Schaltung
Power-on reset circuit with protection against power failures for an integrated circuit

(30) Priorité: 22.12.1992 FR 9215522
(43) Date de publication de la demande: 29.06.1994
(73) Titulaire: SGS-THOMSON MICROELECTRONICS S.A., F-94250 Gentilly (FR)
(72) Inventeur: Guedj, Marc, F-75116 Paris (FR)
(74) Mandataire: Schmit, Christian Norbert Marie

(56) Documents cités:
- EP-A- 0 150 480
- EP-A- 0 195 358
- EP-A- 0 471 542
- US-A- 4 096 560
- JAPANESE JOURNAL OF APPLIED PHYSICS, SUPPLEMENTS 17TH CONFERENCE ON SOLID STATE DEVICES AND MATERIALS 25 Aoüt 1985 , TOKYO JA pages 49 - 52 SAWADA K. ET AL 'On-Chip Battery Back-Up Circuit for VLSI Static RAM's'

## Description

L'invention concerne les circuits intégrés, et plus précisément un circuit de démarrage permettant d'assurer temporairement l'inhibition de certaines fonctions du circuit intégré au moment de la mise sous tension. En effet, dans certains circuits logiques, des fonctionnements erronés peuvent être engendrés du fait de l'insuffisance de la tension d'alimentation. Pour éviter ces fonctionnements erronés, on préfère inhiber complètement certaines fonctions du circuit intégré pendant la mise sous tension.

On utilise pour cela un circuit de démarrage qui produit un créneau de tension débutant au moment de la mise sous tension et se prolongeant au moins jusqu'à ce que la tension d'alimentation ait atteint une valeur suffisante. Ce créneau est appliqué à une entrée d'inhibition de chacun des circuits dont le fonctionnement doit être inhibé temporairement.

Typiquement, pour une tension d'alimentation nominale de 5 volts, on s'arrange pour produire un créneau d'inhibition qui démarre au moment de la mise sous tension et qui se poursuit en général pendant une durée de quelques millisecondes à quelques dizaines de millisecondes après que la tension d'alimentation ait dépassé un seuil d'environ 3 à 3,3 volts, acceptable pour le fonctionnement du circuit intégré.

Un circuit de démarrage semble par exemple indispensable pour les circuits à mémoire non volatile électriquement programmable et effaçable (EEPROM), et tout particulièrement lorsque cette mémoire est organisée en mots de plusieurs bits écrits ou effacés en parallèle. En effet, il y a alors un risque de programmation indésirable de la mémoire par suite d'instructions non fiables données pendant le début de la mise sous tension du circuit. Ceci est critique dans le cas par exemple de circuits de carte à puce à mémoire EEPROM où le contenu de la mémoire doit être parfaitement fiable.

En général, dans les circuits de démarrage de l'art antérieur, la tension de sortie du circuit de démarrage, c'est-à-dire la tension qui est appliquée à une entrée d'inhibition d'un circuit dont le fonctionnement doit être interdit, suit les évolutions suivantes : au début elle suit d'assez près la tension d'alimentation, puis, lorsque la tension d'alimentation dépasse un seuil déterminé, une temporisation est déclenchée de sorte que le signal d'inhibition dure alors un certain temps, après quoi il s'interrompt. Si la tension d'alimentation varie ensuite et redescend momentanément au dessous du seuil, le signal d'inhibition peut réapparaître, et il suit alors les variations de la tension d'alimentation, mais sans redéclenchement d'une temporisation.

Le document EP-A-0 471 542 divulgue un circuit de démarrage comprenant un premier circuit qui, à partir d'un seuil de tension, fait basculer une bascule de mémorisation et un second circuit qui fait basculer ladite bascule dans l'état inverse quand la tension d'alimentation chute à zéro.

On s'est aperçu que dans certains cas, la fiabilité du circuit intégré restait insuffisante.

Pour améliorer cette fiabilité, l'invention propose un circuit de démarrage, dans un circuit intégré alimenté par une tension d'alimentation Vcc, le circuit de démarrage comprenant des moyens pour produire un signal d'inhibition lorsque la tension d'alimentation n'a pas encore atteint un premier seuil de tension, ce signal d'inhibition étant appliqué à une entrée d'inhibition d'un circuit dont on veut inhiber le fonctionnement pendant la mise sous tension du circuit intégré, ce circuit de démarrage étant caractérisé en ce qu'il comporte en outre des moyens pour redéclencher un signal d'inhibition lorsque la tension d'alimentation Vcc chute d'au moins une valeur déterminée, telle que la tension d'alimentation reste alors au dessus du premier seuil.

Le circuit de démarrage agit donc aussi comme circuit de sécurité contre les variations non négligeables de la tension d'alimentation.

Typiquement, pour une tension Vcc nominale de 5 volts, le premier seuil est de préférence le même que dans l'art antérieur, à savoir environ 3 à 3,3 volts. La chute de tension qui fait redéclencher le signal d'inhibition est de préférence d'environ 1 volt. Si la tension d'alimentation nominale Vcc0 est 5 volt, cela correspond alors à un redéclenchement du signal d'inhibition pour un deuxième seuil d'environ 4 volts.

Tout particulièrement dans le cas de circuits à mémoire EEPROM organisée en mots de plusieurs bits, on s'est aperçu qu'un tel circuit était plus fiable que les circuits de démarrage de l'art antérieur. Le signal d'inhibition inhibe alors les circuits d'écriture dans la mémoire, mais il n'est pas nécessaire qu'il inhibe les circuits de lecture.

De préférence, des moyens de temporisation sont prévus pour que le signal d'inhibition se prolonge pendant une certaine durée après que la tension d'alimentation ait dépassé le premier seuil et après le redéclenchement sous l'effet d'une chute de tension. Cette durée est brève et peut être de l'ordre de quelques millisecondes. Après cette durée, le signal d'inhibition s'interrompt.

Le circuit de démarrage selon l'invention comporte de préférence :
- un premier et un second détecteurs de dépassement de seuil, fournissant tous deux un signal de dépassement si la tension d'alimentation dépasse le seuil,
- une première porte logique recevant les signaux issus de ces deux détecteurs et basculant lorsque les deux circuits fournissent un signal de dépassement,
- un détecteur de chute de tension de l'alimentation, fournissant un signal impulsionnel si la tension d'alimentation chute d'au moins une valeur déterminée, la sortie de ce détecteur de chute de tension étant connectée à une première entrée de la première porte logique pour faire basculer celle-ci momentanément en sens inverse,
- la sortie de la première porte fournissant un signal de contrôle du signal d'inhibition.

De préférence encore, le premier détecteur de dépassement de seuil est relié à la première entrée de la première porte logique, et le deuxième détecteur de dépassement est relié à une deuxième entrée de cette porte, le deuxième détecteur peut être inhibé par un signal de redéclenchement, et il est prévu une deuxième porte logique recevant d'une part la sortie de la première porte et d'autre part la sortie du circuit de détection de chute de tension, cette deuxième porte fournissant le signal de redéclenchement lorsqu'elle reçoit le signal impulsionnel alors que la tension d'alimentation est au dessus du seuil.

La sortie de la première porte logique est de préférence reliée à un inverseur, et une capacité est de préférence placée entre cette sortie et une masse. La sortie de l'inverseur fournit le signal d'inhibition, et la capacité sert à établir un retard entre le moment où la première porte bascule et le moment où l'inverseur bascule et interrompt le signal d'inhibition.

De préférence encore, le deuxième détecteur comporte des moyens pour retarder l'émission d'un signal de dépassement de seuil par rapport au moment où la tension d'alimentation dépasse ce seuil, et par rapport à la fin du signal de redéclenchement.

Le circuit de détection de chute de tension comporte de préférence un premier transistor à très faible tension de seuil ayant son drain et sa grille reliés à la tension d'alimentation et sa source reliée à une capacité de stockage, et un deuxième transistor à canal P dont la tension de seuil est sensiblement égale à la chute de tension dont on veut détecter le dépassement, ce deuxième transistor ayant sa source reliée à la source du premier transistor et à la capacité, sa grille reliée à la tension d'alimentation, et son drain constituant la sortie du circuit de détection de chute de tension.

D'autres caractéristiques et avantages de l'invention apparaîtront à la lecture de la description détaillée qui suit et qui est faite en référence aux dessins annexés dans lesquels :
- la figure 1 représente un circuit intégré comportant un circuit de démarrage;
- la figure 2 représente un schéma bloc du circuit de démarrage selon l'invention;
- la figure 3 représente un schéma détaillé de ce circuit;
- la figure 4 représente un diagramme temporel du signal d'inhibition en présence de variations de la tension d'alimentation.

Le circuit de démarrage CD, qu'on peut aussi appeler circuit d'inhibition temporaire, est connu également sous le nom anglais de "Power On Reset Circuit"; il fait partie d'un circuit intégré IC, par exemple un circuit de carte à mémoire comportant une mémoire MNV, de type EEPROM.

La mémoire peut être écrite ou effacée grâce à un automate d'écriture CW. La mémoire doit être protégée contre une écriture d'informations erronées, en particulier lorsque la tension d'alimentation est trop faible, et ceci surtout si la mémoire est organisée en mots de plusieurs bits. Le circuit de démarrage fournit un signal d'inhibition INH qui est appliqué à une entrée d'inhibition du circuit CW, pour interdire son fonctionnement dans ce cas.

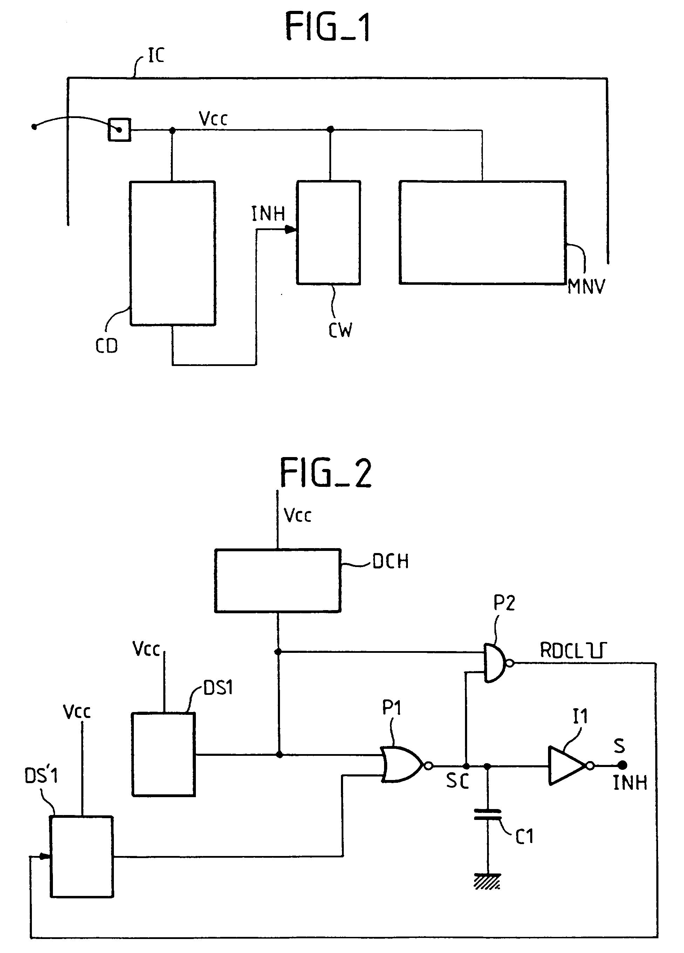

Un schéma simplifié du circuit de démarrage selon l'invention est représenté à la figure 2.

Le circuit de démarrage comprend deux circuits DS1 et DS'1 de détection de dépassement d'un seuil de tension VS1; VS1 peut être typiquement de 3 volts à 3,3 volts, pour une alimentation nominale Vcc0 de 5 volts.

Ces circuits DS1 et DS'1 fournissent chacun un niveau logique en fonction de la valeur de la tension d'alimentation réelle Vcc par rapport à VS1. Ces niveaux logiques sont appliqués aux deux entrées d'une première porte logique P1. La porte P1, de préférence une porte NOR, bascule lorsque les deux détecteurs fournissent un niveau logique bas indiquant le dépassement de VS1 par Vcc. Le deuxième détecteur DS'1 comporte de préférence des moyens pour retarder le changement d'état de sa sortie après l'instant où Vcc dépasse effectivement VS1.

Des circuits non représentés sur la figure 2 peuvent être prévus pour s'assurer que les niveaux logiques sur les entrées de la porte P1 sont tous deux au niveau haut au démarrage du circuit.

Le signal de détection de dépassement issu du circuit DS'1 peut être neutralisé par un signal extérieur. Le niveau logique bas émis par le circuit DS'1 peut donc être inhibé (remplacé par un niveau logique haut ou par un état de haute impédance) même si Vcc est toujours supérieur à VS1.

La sortie de la porte P1 constitue un signal logique SC qui est un signal de contrôle du signal d'inhibition INH qu'on cherche à produire. Elle est appliquée à l'entrée d'un inverseur I1 dont la sortie S fournit le signal INH. Une capacité C1 est placée entre la sortie de la porte P1 et une masse, pour retarder la transition vers le bas du signal INH par rapport à la transition logique vers le haut du signal SC.

Si on résume ce qui vient d'être dit : la porte P1 fournit un niveau logique bas pendant le démarrage, et INH est donc au niveau logique haut pendant ce temps, jusqu'à ce que Vcc dépasse le seuil VS1; alors, éventuellement après un retard introduit par le détecteur DS'1, le signal SC passe au niveau haut, mais le signal INH ne passe pas tout de suite à zéro grâce à la capacité C1. L'interruption du signal d'inhibition dure donc tant que Vcc reste inférieure à VS1 et une certaine durée au delà (en général quelques nanosecondes).

Un circuit DCH, de détection d'une chute de tension importante de Vcc est prévu. Ce circuit est relié entre Vcc et une des entrées de la porte P1, ici la première entrée, reliée à la sortie du circuit de détection DS1. Le circuit DCH fournit une impulsion brève lorsque Vcc descend d'une quantité supérieure à une valeur déterminée Vl. L'impulsion brève est un front montant qui fait basculer la porte P1, celle-ci ayant à ce moment ses deux entrées au niveau logique bas.

Ce basculement a pour conséquence la décharge rapide de la capacité C1 et donc le démarrage d'une impulsion d'inhibition INH. On sait réaliser l'étage de sortie de la porte P1 pour que la décharge de C1 après transition négative de la porte soit beaucoup plus rapide que la charge après transition positive.

D'autre part, une deuxième porte logique P2 (dans cet exemple une porte NON-ET) reçoit d'une part la sortie de la porte P1 et d'autre part la sortie du circuit de détection DCH qui est en même temps la sortie du circuit DS1. La sortie de cette porte P2 est au niveau logique haut pendant le démarrage normal du circuit intégré (parce que soit la sortie de la porte P1 est au niveau bas, soit la sortie du circuit DS1 est au niveau bas), et elle est également au niveau haut pendant le fonctionnement normal du circuit intégré, c'est-à-dire lorsque Vcc ne subit pas de chute brusque de tension; en effet, la sortie du circuit DS1 reste alors au niveau bas.

Mais si le circuit de détection de chute de tension de Vcc fournit une impulsion brève au niveau haut, en fonctionnement normal, c'est-à-dire alors que le signal SC est au niveau haut, alors la porte P2 bascule, et elle fournit une impulsion de redéclenchement ou réinitialisation RDCL. Cette impulsion RDCL (créneau vers le bas) est appliquée au deuxième circuit de détection de seuil DS'1 pour neutraliser sa sortie malgré le fait que Vcc soit supérieur à VS1.

Le deuxième circuit DS'1 cesse alors de maintenir au niveau bas la deuxième entrée de la porte P1 et permet même, par des moyens non représentés à la figure 2, de mettre cette entrée au niveau haut.

Aussitôt après la fin de l'impulsion brève issue du circuit DCH, la porte P2 revient à son état initial, le détecteur DS'1 cesse de recevoir le signal de neutralisation RDCL, et il reprend sa fonction normale de détecteur de dépassement de seuil de Vcc.

On a alors atteint une situation qui est la même qu'au moment où, après la mise sous tension, Vcc atteint le seuil VS1 : les deux détecteurs DS1 et DS'1 fournissent un niveau logique bas, avec toutefois de préférence un certain retard pour DS'1 par rapport au moment où le signal de redéclenchement RDCL se termine. La porte P1 bascule à nouveau, et au bout d'une durée liée à la valeur de la capacité C1, le signal d'inhibition INH est à nouveau interrompu.

Si on résume cette partie du fonctionnement du circuit de démarrage : lorsque Vcc chute d'au moins une valeur Vl déterminée (par exemple 1 volt), définie par le détecteur DCH, une impulsion brève est émise par le circuit DCH; cette impulsion fait basculer les portes P1 et P2. Le signal d'inhibition INH démarre. Simultanément, le détecteur de seuil DS'1 est neutralisé. Puis le détecteur DS'1 retrouve sa fonction normale et tout se passe comme dans le cas d'une mise sous tension. Le signal INH subsiste jusqu'à ce que DS'1 ait fourni à nouveau un niveau logique bas et que l'inverseur I1 ait rebasculé.

Le circuit de démarrage selon l'invention agit donc aussi comme circuit de sécurité en cas de chute importante de la tension d'alimentation (par exemple Vcc passe à 4 volt au lieu de sa valeur nominale 5 volts), et ceci même si la tension d'alimentation ne descend pas au dessous du seuil normal VS1 de remise en route du circuit.

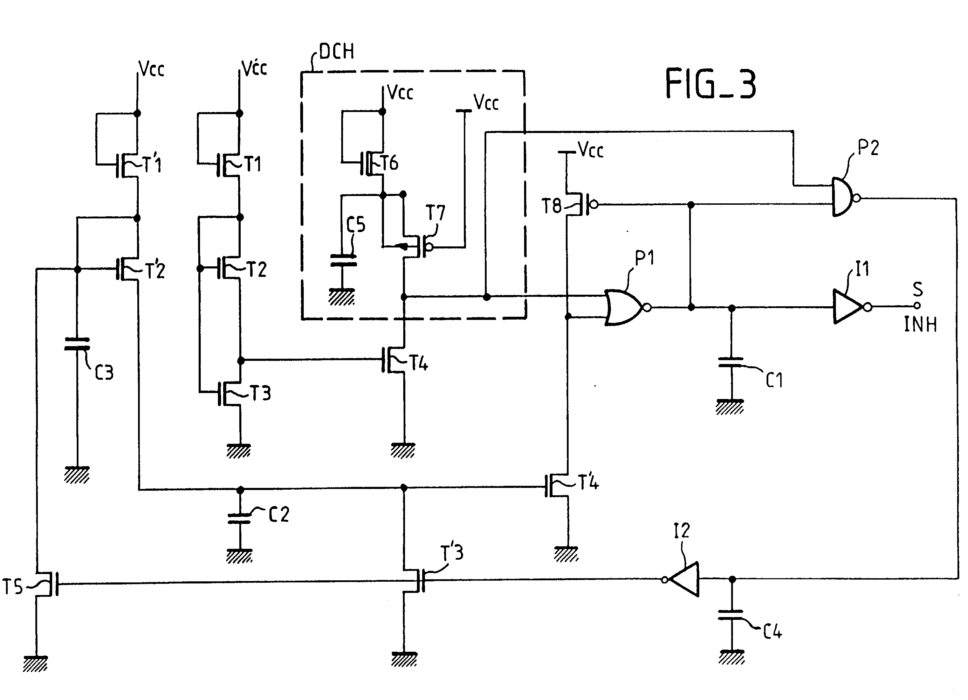

On va maintenant décrire un mode de réalisation très détaillée du circuit selon l'invention, en référence à la figure 3.

Ce circuit est réalisé à l'aide de transistors MOS de trois types différents : des transistors à canal N enrichis, des transistors à canal P enrichis, et des transistors à canal N natifs. Les transistors natifs ont une tension de seuil très proche de zéro, et les transistors enrichis ont en valeur absolue une tension de seuil plus élevée que les transistors natifs, par exemple 1 ou 1,1 volt. Les transistors à canal N natifs ont pour zone de canal entre source et drain le substrat semiconducteur de type P dans lequel sont formés tous les transistors à canal N du circuit intégré, sans dopage supplémentaire du canal. Les transistors enrichis ont une implantation d'impuretés supplémentaire dans leur canal, de type P pour les transistors à canal N et de type N pour les transistors à canal P.

Les tensions de seuil des transistors sont utilisées pour établir les seuils de déclenchement du signal d'inhibition.

Le premier détecteur de dépassement de seuil DS1 comprend trois transistors à canal N enrichis T1, T2, T3, en série entre Vcc et la masse, et un quatrième transistor T4. T1 a sa grille et son drain reliés à Vcc; T2 a sa grille et son drain reliés à la source de T1; T3 a sa grille reliée à celle de T2 et son drain à la source de T2, sa source étant à la masse. T4 a sa grille reliée au drain de T3 et sa source à la masse. Le drain de T4 constitue la sortie du détecteur DS1 et est relié à la première entrée de la porte NOR P1. T4 est rendu conducteur lorsque Vcc dépasse un seuil VS1 qui est approximativement égal à la somme des tensions de seuil des transistors à canal N enrichis T1, T2, T4. Le transistor T3, de petite taille, sert surtout à polariser les transistors T1 et T2.

Le détecteur DS'1 comporte quatre transistors T'1, T'2, T'3, T'4, qui sont montés pratiquement comme les transistors T1, T2, T3, T4 respectivement. Toutefois, la grille de T'3 n'est pas reliée à celle de T'2 mais elle est commandée par un inverseur I2 placé en sortie de la porte NAND P2, ceci en vue de la neutralisation de la sortie de DS'1. Une capacité C2 connectée entre le drain de T'2 et la masse permet d'assurer la polarisation des transistors T'4 et T'2 pendant la montée de Vcc à la mise sous tension. La sortie du détecteur DS'1, prélevée sur le drain de T'4, est reliée à la deuxième entrée de la porte P1.

De plus, on prévoit de préférence une capacité C3 entre la grille de T'2 raccordée à la source de T'1 et la masse.

Cette capacité C3 permet également d'assurer la polarisation des transistors T'1 et T'2 pendant la montée de Vcc à la mise sous tension.

Cette capacité C3 peut être déchargée par un transistor T5 qui vient la court-circuiter lorsque le signal de redéclenchement RDCL est émis par la porte P2. Le transistor T5 est commandé par l'inverseur I2.

Une capacité C4 est de préférence placée entre l'entrée de l'inverseur I2 et la masse, pour retarder légèrement le blocage des transistors T5 et T'3 par rapport à la fin du signal de redéclenchement en sortie de la porte P2. On assure ainsi une durée de neutralisation suffisante pour le détecteur DS'1.

Le détecteur de chute de tension DCH comporte un transistor N natif T6 en série avec un transistor P T7, et une capacité C5. T6 a son drain et sa grille reliés à Vcc; T7 a sa source reliée à la source de T6, sa grille reliée à Vcc, et son drain constitue la sortie du détecteur, reliée à la première entrée de la porte P1 et reliée également à une entrée de la porte P2. Le substrat du transistor T7 est relié à sa source. La capacité C5 est reliée entre la source du transistor T6 (c'est-à-dire aussi de T7) et la masse.

Lorsque Vcc monte et atteint sa valeur nominale, le transistor T7 à canal P ne peut qu'être bloqué, sa source étant à un potentiel plus faible que sa grille. Le transistor T6 au contraire est conducteur tant que la capacité C5 est déchargée; la capacité C5 se charge donc, pratiquement jusqu'à Vcc puisque le transistor T6 a une tension de seuil très proche de zéro.

Tant que Vcc conserve sa valeur nominale Vcc0, par exemple 5 volts, la capacité C5 reste chargée à cette valeur nominale Vcc0. Elle ne peut pas se décharger dans T7 qui est bloqué. Mais si Vcc baisse au dessous de Vcc0, le transistor T6 se bloque, empêchant toute décharge de la capacité vers la source à Vcc; C5 conserve donc la tension Vcc0. Et si la tension Vcc baisse d'au moins une valeur Vl égale à la tension de seuil du transistor P, par exemple 1 volt, alors T7 se met à conduire (puisque sa grille passe suffisamment au dessous de son drain). La capacité C5 se décharge alors brusquement dans le transistor T4 qui est conducteur.

L'impulsion de tension qui en résulte sur la première entrée des portes P1 et P2 est l'impulsion brève qu'on a mentionnée en référence à la figure 2 et qui provoque la réinitialisation d'un signal d'inhibition INH.

Sur la figure 3, on voit encore un transistor T8 à canal P, connecté entre Vcc et la deuxième entrée de la porte P1, et commandé par la sortie de la porte P1. Ce transistor permet de maintenir à l'état logique haut (et non un état flottant) la deuxième entrée de la porte P1 pendant la présence du signal d'inhibition INH. Le transistor T8 est suffisamment petit par rapport à T'4 pour que la mise en conduction de T'4 fasse basculer la porte P1 (lorsque T4 est aussi conducteur bien entendu).

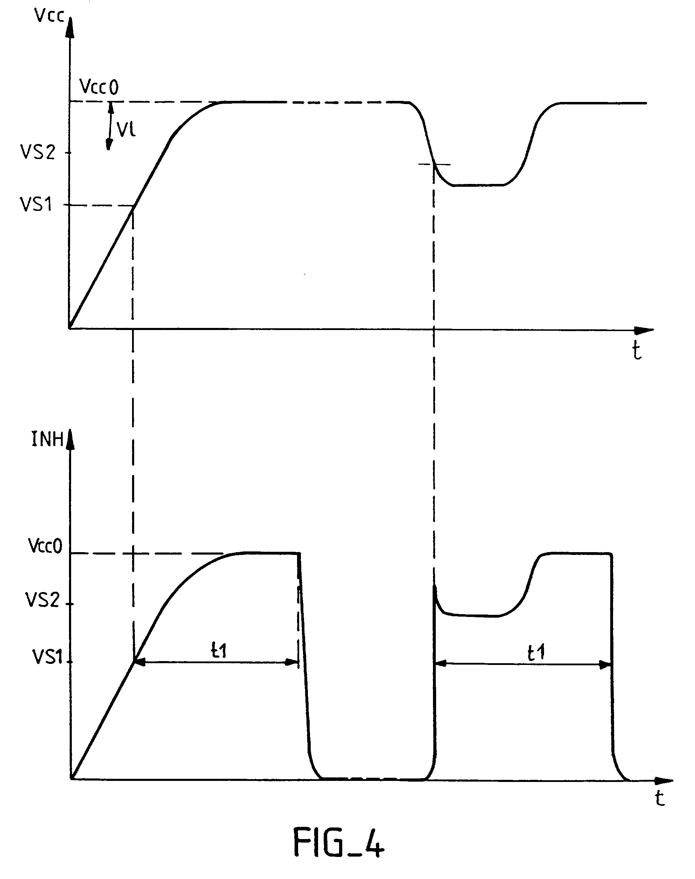

La figure 4 représente l'évolution du signal d'inhibition INH pour un exemple d'évolution de la tension Vcc : lors de la mise en route, Vcc croît et le signal INH croît en suivant sensiblement Vcc. Lorsque Vcc atteint VS1, la porte P1 bascule, éventuellement avec un léger retard dû à la présence des capacités C2 et C3. Puis, l'inverseur I1 bascule à son tour, avec également un retard dû à la capacité C1. Le signal INH retombe alors à zéro. La durée du signal d'inhibition à la mise en route est la somme de la durée que met Vcc à atteindre VS1 et une durée t1 qui correspond aux retards introduits par les capacités.

Pendant cette durée la tension Vcc a en principe atteint sa valeur nominale Vcc0, mais de toutes façons le circuit intégré est autorisé à fonctionner dès la retombée à zéro du signal INH.

Si la tension d'alimentation Vcc baisse ensuite d'une valeur supérieure à Vl, Vₗ = V_{cc0} - VS2 , le signal d'inhibition est instantanément redéclenché. Le seul retard au déclenchement est dû au temps de réponse des portes P1 et I1 et au temps de décharge de la capacité C1, mais on peut prévoir que ce dernier est beaucoup plus faible que le temps de charge. Il suffit de concevoir le dernier étage de P1 en conséquence, avec un gros transistor à canal N et un petit transistor à canal P.

Le signal INH suit alors les variations de tension de Vcc. Bien entendu, si Vcc descend au dessous du seuil VS1, on se retrouve dans la configuration classique d'une remise en route générale (comme au démarrage).

Mais si Vcc reste au dessus de VS1, le signal d'inhibition subsiste et suit les variations de Vcc pendant une durée qui est sensiblement la même durée t1 qu'on a mentionnée précédemment, résultant des retards introduits par les diverses capacités; la durée peut même être plus longue si on tient compte des temps de décharge puis recharge de la capacité C4 au moment de la réinitialisation.

## Revendications

1. Circuit de démarrage pour un circuit intégré alimenté par une tension d'alimentation Vcc, comprenant des moyens pour produire un signal d'inhibition (INH) lorsque la tension d'alimentation n'a pas encore atteint un premier seuil de tension (VS1), ce signal d'inhibition étant appliqué à une entrée d'inhibition d'un circuit dont on veut inhiber le fonctionnement pendant la mise sous tension du circuit intégré, ce circuit de démarrage étant caractérisé en ce qu'il comporte en outre des moyens (DCH, P2) pour redéclencher un signal d'inhibition lorsque la tension d'alimentation Vcc chute d'au moins une valeur déterminée (Vl) telle que la tension d'alimentation Vcc reste alors au dessus du premier seuil (VS1).

2. Circuit de démarrage selon la revendication 1, caractérisé en ce que des moyens de temporisation (C1, C2, C3, C4) sont prévus pour que le signal d'inhibition se prolonge pendant une certaine durée après que la tension d'alimentation ait dépassé le premier seuil et après le redéclenchement sous l'effet d'une chute de tension d'alimentation.

3. Circuit selon la revendication 2, caractérisé en ce que la durée est de quelques millisecondes.

4. Circuit selon l'une des revendications 1 à 3, caractérisé en ce qu'il comporte :
- un premier et un second détecteurs de dépassement de seuil (DS1, DS'1), fournissant tous deux un signal de dépassement si la tension d'alimentation dépasse le seuil (VS1),
- une première porte logique (P1) recevant les signaux issus de ces deux détecteurs et basculant lorsque les deux circuits fournissent un signal de dépassement,
- un détecteur (DCH) de chute de tension de l'alimentation, fournissant un signal impulsionnel si la tension d'alimentation chute d'au moins une valeur déterminée, la sortie de ce détecteur de chute de tension étant connectée à une première entrée de la première porte logique pour faire basculer celle-ci momentanément en sens inverse,
- la sortie de la première porte fournissant un signal de contrôle du signal d'inhibition.

5. Circuit selon la revendication 4, caractérisé en ce que le premier détecteur de dépassement de seuil (DS1) est relié à la première entrée de la première porte logique (P1), et le deuxième détecteur de dépassement est relié à une deuxième entrée de cette porte, en ce que le deuxième détecteur (DS'1) peut être inhibé par un signal de redéclenchement (RDCL), et en ce qu'il est prévu une deuxième porte logique (P2) recevant d'une part la sortie de la première porte et d'autre part la sortie du circuit de détection de chute de tension (DCH), cette deuxième porte fournissant le signal de redéclenchement lorsqu'elle reçoit le signal impulsionnel alors que la tension d'alimentation est au dessus du seuil (VS1).

6. Circuit selon la revendication 5, caractérisé en ce que la sortie de la première porte logique est reliée à un inverseur (I1).

7. Circuit selon la revendication 6, caractérisé en ce qu'une capacité (C1) est placée entre cette sortie et une masse.

8. Circuit selon la revendication 7, caractérisé en ce que le deuxième détecteur comporte des moyens (C2, C3) pour retarder l'émission d'un signal de dépassement de seuil par rapport au moment où la tension d'alimentation dépasse ce seuil, et par rapport à la fin du signal de redéclenchement (RDCL).

9. Circuit selon l'une des revendications précédentes, caractérisé en ce que le circuit de détection de chute de tension (DCH) comporte un premier transistor (T6) à très faible tension de seuil ayant son drain et sa grille reliés à la tension d'alimentation et sa source reliée à une capacité de stockage (C5), et un deuxième transistor (T7) à canal P dont la tension de seuil est sensiblement égale à la chute de tension dont on veut détecter le dépassement, ce deuxième transistor ayant sa source reliée à la source du premier transistor et à la capacité de stockage, sa grille reliée à la tension d'alimentation, et son drain constituant la sortie du circuit de détection de chute de tension.

10. Circuit selon l'une des revendications précédentes, caractérisé en ce que la tension d'alimentation a une valeur nominale de 5 volts, le premier seuil (VS1) est d'environ 3 à 3,3 volts, et la chute de tension déterminée qui fait redéclencher le signal d'inhibition est d'environ 1 volt.

11. Circuit selon l'une des revendications précédentes, caractérisé en ce que le signal d'inhibition (INH) est appliqué à une entrée d'inhibition d'un circuit d'écriture de mémoire EEPROM.

## Patentansprüche

1. Startschaltung für eine integrierte Schaltung, die mit einer Speisespannung Vcc versorgt wird und Vorrichtungen zur Herstellung eines Sperrsignals (INH) umfaßt, wenn die Speisespannung einen ersten Spannungsschwellenwert (VS1) noch nicht erreicht hat, wobei dieses Sperrsignal an einen Sperreingang einer Schaltung angelegt wird, deren Funktion während der Unterspannungsetzung der integrierten Schaltung blockiert werden soll, und dieser Startkreis dadurch gekennzeichnet ist, daß er außerdem Vorrichtungen (DCH, P2) zum erneuten Auslösen eines Sperrsignals umfaßt, wenn die Speisespannung Vcc um mindestens einen bestimmten Wert (V1) abfällt, so daß die Speisespannung Vcc dann über dem ersten Schwellenwert (VS1) bleibt.

2. Schaltung nach Anspruch 1, dadurch gekennzeichnet, daß Zeitverzögerungsvorrichtungen (C1, C2, C3, C4) vorgesehen sind, damit das Sperrsignal während einer bestimmten Dauer anhält, nachdem die Speisespannung den ersten Schwellenwert überschritten hat und nach Wiederauslösung durch Wirkung eines Speisespannungsabfalls.

3. Schaltung nach Anspruch 2, dadurch gekennzeichnet, daß die Dauer einige Millisekunden beträgt.

4. Schaltung nach einem der Ansprüche 1 bis 3, dadurch gekennzeichnet, daß sie umfaßt:
- eine erste und eine zweite Vorrichtung zur Erfas-sung einer Schwellenüberschreitung (DS1, DS'1), die beide ein Überschreitungssignal liefern, wenn die Speisespannung den Schwellenwert (VS1) überschreitet,
- ein erstes logisches Gatter (P1), das die von diesen beiden Erfassungsvorrichtungen kommenden Signale empfängt und umkippt, wenn die beiden Schaltungen ein Überschreitungssignal liefern,
- eine Vorrichtung zur Erfassung (DCH) eines Speisespannungsabfalls, die ein Impulssignal liefert, wenn die Speisespannung um mindestens einen bestimmten Wert sinkt, wobei der Ausgang dieser Speisespannungserfassungsvorrichtung mit einem ersten Eingang des ersten logischen Gatters verbunden ist, um dieses vorübergehend in die umgekehrte Richtung umzukippen,
- wobei der Ausgang des ersten Gatters ein Sperrsignal-Kontrollsignal liefert.

5. Schaltung nach Anspruch 4, dadurch gekennzeichnet, daß die erste Schwellenwertüberschreitungserfassungsvorrichtung (DS1) mit dem ersten Eingang des ersten logischen Gatters (P1) und daß die zweite Überschreitungserfassungsvorrichtung mit einem zweiten Eingang dieses Gatters verbunden ist, dadurch, daß die zweite Erfassungsvorrichtung (DS'1) durch ein Wiederauslösungssignal (RDCL) blockiert werden kann, sowie dadurch, daß ein zweites logisches Gatter (P2) vorgesehen ist, das einerseits den Ausgang des ersten Gatters und andererseits den Ausgang der Spannungsabfallerfassungsschaltung (DCH) aufnimmt, wobei dieses zweite Gatter das Wiederauslösungssignal liefert, wenn es das Impulssignal empfängt, während die Speisespannung über dem Schwellenwert (VS1) liegt.

6. Schaltung nach Anspruch 5, dadurch gekennzeichnet, daß der Ausgang des ersten logischen Gatters mit einem Inverter (I1) verbunden ist.

7. Schaltung nach Anspruch 6, dadurch gekennzeichnet, daß ein C-Glied (C1) zwischen diesen Ausgang und einer Masse geschaltet ist.

8. Schaltung nach Anspruch 7, dadurch gekennzeichnet, daß die zweite Erfassungsvorrichtung Mittel (C2, C3) zur Verzögerung der Ausgabe eines Schwellenwertüberschreitungssignals bezogen auf den Moment, in dem die Speisespannung diesen Schwellenwert überschreitet, und bezogen auf das Ende des Wiederauslösungssignals (RDCL) umfaßt.

9. Schaltung nach einem der vorstehenden Ansprüche, dadurch gekennzeichnet, daß die Spannungsabfallerfassungsschaltung (DCH) einen ersten Transistor (T6) mit sehr geringer Schwellenspannung umfaßt, dessen Drain und Gitter mit der Speisespannung verbunden sind und dessen Quelle mit einer Speicherkapazität (C5) verbunden ist, sowie einen zweiten Transistor (T7) mit einem Kanal P, dessen Schwellenspannung im wesentlichen gleich dem Spannungsabfall ist, dessen Überschreitung erfaßt werden soll, wobei die Quelle dieses zweiten Transistors mit der Quelle des ersten Transistors und sein Gitter mit der Speicherkapazität verbunden ist und sein Drain den Ausgang der Spannungsabfallerfassungsschaltung bildet.

10. Schaltung nach einem der vorstehenden Ansprüche, dadurch gekennzeichnet, daß die Speisespannung einen Nennwert von 5 Volt hat, wobei der erste Schwellenwert (VS1) bei 3 bis 3,3 Volt liegt und der bestimmte Spannungsabfall, der das Sperrsignal wiederauslöst, etwa 1 Volt beträgt.

11. Schaltung nach einem der vorstehenden Ansprüche, dadurch gekennzeichnet, daß das Sperrsignal (INH) an einen Sperreingang einer EEPROM-Speicherschreibeschaltung angelegt wird.

## Claims

1. Start-up circuit for an integrated circuit fed with a supply voltage Vcc, comprising means for producing an inhibiting signal (INH) when the supply voltage has yet to reach a first voltage threshold (VS1), this inhibiting signal being applied to an inhibiting input of a circuit whose operation is to be inhibited during the powering of the integrated circuit, this start-up circuit being characterised in that it also includes means (DCH, P2) for re-triggering an inhibiting signal when the supply voltage Vcc drops by at least a predetermined value (Vl) so that the supply voltage Vcc then remains above the first threshold (VS1).

2. Start-up circuit according to Claim 1, characterised in that timing means (C1, C2, C3, C4) are provided in order for the inhibiting signal to be extended for a certain period after the supply voltage has exceeded the first threshold and after the re-triggering under the effect of a drop in the supply voltage.

3. Circuit according to Claim 2, characterised in that the period is a few milliseconds.

4. Circuit according to one of Claims 1 to 3, characterised in that it has:
- first and second devices (DS1, DS'1) detecting that the threshold has been exceeded, both supplying a threshold-exceeded signal if the supply voltage exceeds the threshold (VS1),
- a first logic gate (P1) receiving the signals coming from these two detectors and switching when the two circuits supply a threshold-exceeded signal,
- a detector (DCH) of supply voltage drop, providing a pulsed signal if the supply voltage drops by at least a predetermined value, the output of this voltage drop detector being connected to a first input of the first logic gate, to switch the latter momentarily in the opposite direction,
- the output of the first gate supplying a control signal for the inhibiting signal.

5. Circuit according to Claim 4, characterised in that the first device (DS1) detecting exceeding of the threshold is connected to the first input of the first logic gate (P1), and the second device detecting exceeding of the threshold is connected to a second input of this gate, in that the second detector (DS'1) can be inhibited by a re-triggering signal (RDCL), and in that a second logic gate (P2) is provided which receives firstly the output from the first gate and secondly the output from the voltage drop detection circuit (DCH), this second gate supplying the re-triggering signal when it receives the pulsed signal when the supply voltage is above the threshold (VS1).

6. Circuit according to Claim 5, characterised in that the output of the first logic gate is connected to an inverter (I1).

7. Circuit according to Claim 6, characterised in that a capacitor (C1) is placed between this output and earth.

8. Circuit according to Claim 7, characterised in that the second detector has means (C2, C3) for delaying the transmission of a threshold-exceeded signal with respect to the moment the supply voltage exceeds this threshold, and with respect to the end of the re-triggering signal (RDCL).

9. Circuit according to one of the preceding claims, characterised in that the voltage drop detection signal (DCH) has a first transistor (T6) with a very low threshold voltage, having its drain and gate connected to the supply voltage and its source connected to a storage capacitor (C5), and a second p-channel transistor (T7) whose threshold voltage is substantially equal to the voltage drop whose exceeding is to be detected, this second transistor having its source connected to the source of the first transistor and to the storage capacitor, its gate connected to the supply voltage, and its drain constituting the output of the voltage drop detection circuit.

10. Circuit according to one of the preceding claims, characterised in that the supply voltage has a nominal value of 5 volts, the first threshold (VS1) is around 3 to 3.3 volts, and the predetermined voltage drop which re-triggers the inhibiting signal is around 1 volt.

11. Circuit according to one of the preceding claims, characterised in that the inhibiting signal (INH) is applied to an inhibiting input of the write circuit of an EEPROM memory.
